# EUROPEAN PATENT APPLICATION

(11) **EP 4 779 691 A1**
(43) Date of publication of application: **22.07.2026**
(21) Application number: 23954867.0
(22) Date of filing: 05.10.2023
(51) Int. Cl.: H01L 25/075, H10H 20/85, H10H 20/857, H01L 23/00

(54) **SUBSTRATE FOR ASSEMBLING SEMICONDUCTOR LIGHT-EMITTING DEVICE FOR DISPLAY PIXEL, AND DISPLAY DEVICE COMPRISING SAME**

(71) Applicant: LG Electronics Inc., Yeongdeungpo-gu Seoul 07336 (KR)
(72) Inventor: AN, Jaeyong, Seoul 06772 (KR); SUNG, Junho, Seoul 06772 (KR); HEO, Younho, Seoul 06772 (KR)
(74) Representative: Vossius & Partner Patentanwälte Rechtsanwälte mbB
(86) International application number: PCT/KR2023/015296
(87) International publication number: WO 2025/075219

(57) **Abstract**

An assembly substrate for semiconductor light-emitting devices for display pixels according to an embodiment may include a substrate, a plurality of assembly wirings disposed on the substrate, a barrier disposed on the plurality of assembly wirings and having an assembly hole, and a barrier channel disposed adjacent to the assembly hole.

## Description

### [Technical Field]

An embodiment relates to an assembly substrate for semiconductor light-emitting devices for display pixels and a display device including the same.

### [Background Art]

Large-area displays include a liquid crystal display (LCD), an OLED display, and a micro-LED display.

A micro-LED display is a display using, as a display element, a micro-LED that is a semiconductor light-emitting device having a diameter or cross-sectional area of 100*µ*m or less.

Since the micro-LED display uses the micro-LED that is a semiconductor light-emitting device as a display element, it has excellent performance in many characteristics such as contrast ratio, response speed, color reproduction rate, viewing angle, brightness, resolution, lifetime, light-emitting efficiency, or luminance.

In particular, the micro-LED display has an advantage in that a screen can be separated and combined in a modular manner so that size or resolution can be freely adjusted, and has an advantage in that a flexible display can be implemented.

However, since a large micro-LED display requires millions or more micro-LEDs, there is a technical problem in that it is difficult to transfer the micro-LEDs to a display panel rapidly and accurately.

Transfer technologies that are recently being developed include a pick and place process, a laser lift-off method, or a self-assembly method.

Among these, the self-assembly method is a method in which the semiconductor light-emitting devices find an assembly position by themselves in a fluid, and is advantageous for implementation of a large-area display device.

Recently, U.S. Patent No. 9,825,202 has proposed a micro-LED structure suitable for self-assembly, but research on a technology for manufacturing a display through self-assembly of micro-LEDs is still insufficient.

In particular, in a conventional technology, when transferring millions or more semiconductor light-emitting devices to a large display rapidly, a transfer speed can be improved, but a transfer error rate may increase, so that there is a technical problem in that a transfer yield decreases.

Meanwhile, in a related technology, a transfer process using a self-assembly method using dielectrophoresis (DEP) has been attempted, but there is a problem in that a self-assembly rate is low due to non-uniformity of a DEP force.

In addition, when assembling the semiconductor light-emitting devices, when sequential assembly is performed, there is a problem in that color mixing may occur and an assembly time increases.

### [Technical Problem]

One of technical problems of an embodiment is to implement simultaneous assembly of semiconductor light-emitting devices.

In addition, one of technical problems of an embodiment is to improve a correct assembly rate of semiconductor light-emitting devices.

In addition, one of technical problems of an embodiment is to prevent color mixing in an assembly substrate and a display device.

In addition, one of technical problems of an embodiment is to facilitate collection of unassembled chips.

In addition, one of technical problems of an embodiment is to reduce an assembly time of semiconductor light-emitting devices.

The technical problems of the embodiment are not limited to those described in this section and include those that can be understood through the description of the invention.

### [Technical Solution]

An assembly substrate for semiconductor light-emitting devices for display pixels according to an embodiment may include a substrate; a plurality of assembly wirings disposed on the substrate; a barrier disposed on the plurality of assembly wirings and having an assembly hole; and a barrier channel disposed adjacent to the assembly hole.

In addition, in the embodiment, the assembly hole may include a first assembly hole in which a first semiconductor light-emitting device is assembled and a second assembly hole in which a second semiconductor light-emitting device is assembled, and the barrier channel may include a first barrier channel adjacent to the first assembly hole and a second barrier channel adjacent to the second assembly hole.

In addition, in the embodiment, a width of the first barrier channel may be smaller than a diameter of the first assembly hole.

In addition, in the embodiment, the width of the first barrier channel may be smaller than a diameter of the first semiconductor light-emitting device and may be greater than a diameter of the second semiconductor light-emitting device.

In addition, in the embodiment, the width of the first barrier channel may be greater than a height of the second semiconductor light-emitting device.

In addition, in the embodiment, the assembly hole may include a plurality thereof, and the barrier channel may be integrally formed with the plurality of assembly holes.

In addition, in the embodiment, the assembly hole may include a plurality thereof, and may further include a first region disposed between the plurality of assembly holes and connected to the barrier channel, and a width of the first region may be greater than a width of the barrier channel.

In addition, in the embodiment, the barrier channel may be disposed to vertically overlap any one of the plurality of assembly wirings.

In addition, in the embodiment, a height of the barrier may be positioned higher than a center of gravity of the semiconductor light-emitting device.

In addition, in the embodiment, the height of the barrier may be smaller than 1/2 of a diameter of the semiconductor light-emitting device.

### [Advantageous Effects]

An assembly substrate for semiconductor light-emitting devices for display pixels and a display device including the same according to an embodiment can provide a technical effect of preventing color mixing of semiconductor light-emitting devices.

For example, according to the embodiment, semiconductor light-emitting devices emitting different colors can escape through the barrier channel so that color mixing can be prevented.

In addition, the embodiment can provide a technical effect of implementing simultaneous assembly of semiconductor light-emitting devices.

For example, according to the embodiment, semiconductor light-emitting devices having different sizes can be distinguished using the barrier channel and can be simultaneously assembled.

In addition, the embodiment can provide a technical effect of reducing an assembly time of semiconductor light-emitting devices.

For example, according to the embodiment, the assembly time can be significantly reduced through simultaneous assembly.

In addition, the embodiment can provide a technical effect of facilitating collection of unassembled chips.

For example, according to the embodiment, unassembled chips can be collected by forming a collection region in an area adjacent to the barrier channel.

In addition, the embodiment can provide a technical effect of improving a correct assembly rate of semiconductor light-emitting devices.

For example, according to the embodiment, the correct assembly rate can be improved by designing a height of the barrier to consider a diameter and a center of gravity of the semiconductor light-emitting device.

The technical effects of the embodiment are not limited to those described in this section and include those that can be understood through the description of the invention.

### [Description of Drawings]

FIG. 1 is an exemplary view of a living room of a house in which a display device according to an embodiment is disposed.
FIG. 2 is an enlarged view of a first panel region of the display device of FIG. 1.
FIG. 3 is a cross-sectional view taken along line B1-B2 of region A2 of FIG. 2.
FIG. 4 is an exemplary view in which a light-emitting device for display pixels according to an embodiment is assembled on a substrate by a self-assembly method.
FIG. 5 is a plan view of an assembly substrate studied in internally developed technology.
FIG. 6 is a conceptual view of an assembly substrate for semiconductor light-emitting devices for display pixels according to a first embodiment.
FIG. 7 is a conceptual view of an assembly substrate for semiconductor light-emitting devices for display pixels according to a second embodiment.
FIG. 8 is a conceptual view of an assembly substrate for semiconductor light-emitting devices for display pixels according to a third embodiment.
FIG. 9 is a conceptual view of an assembly substrate for semiconductor light-emitting devices for display pixels according to a fourth embodiment.
FIG. 10 is a conceptual view of an assembly substrate for semiconductor light-emitting devices for display pixels according to a fifth embodiment.
FIG. 11 is a conceptual view of an assembly substrate for semiconductor light-emitting devices for display pixels according to a sixth embodiment.

### [Mode for Invention]

Hereinafter, embodiments disclosed in the present specification will be described in detail with reference to the accompanying drawings. In the following description, suffixes "module" and "unit" for components used herein are assigned or used in combination in consideration of ease of preparation of the specification, and do not have meanings or roles distinguished from each other. In addition, the accompanying drawings are provided to facilitate understanding of the embodiments disclosed in the present specification, and the technical idea disclosed in the present specification is not limited by the accompanying drawings. In addition, when it is mentioned that an element such as a layer, a region, or a substrate exists "on" another component, this includes not only a case in which it exists directly on another element but also a case in which another intermediate element exists therebetween.

The display device described in the present specification may include a digital TV, a mobile phone, a smart phone, a laptop computer, a terminal for digital broadcasting, a PDA (personal digital assistant), a PMP (portable multimedia player), a navigation device, a slate PC, a tablet PC, an ultra-book, a desktop computer, and the like. However, a configuration according to the embodiment described in the present specification may also be applied to a device capable of displaying even in a new product form to be developed later.

Hereinafter, a light-emitting device according to an embodiment and a display device including the same will be described.

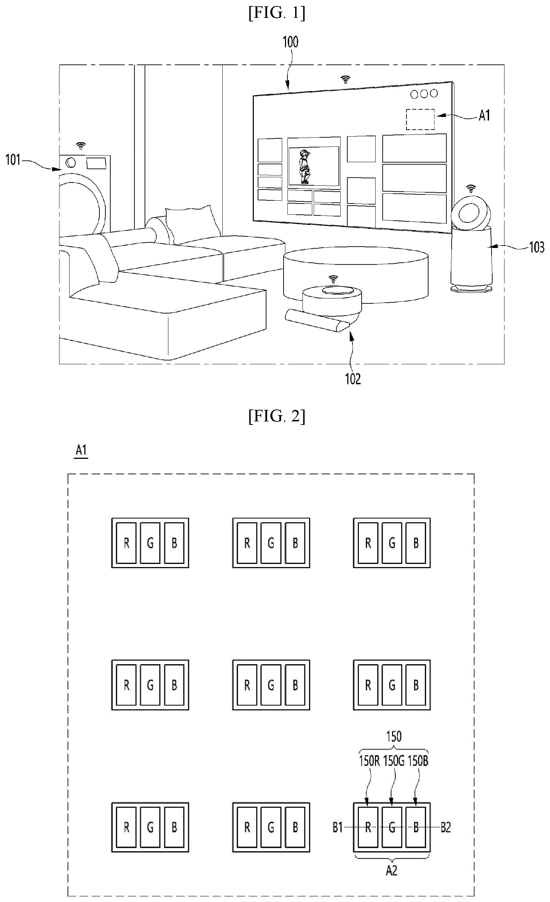

FIG. 1 illustrates a living room of a house in which a display device 100 according to an embodiment is disposed.

The display device 100 according to the embodiment may display states of various electronic products such as a washing machine 101, a robot cleaner 102, and an air purifier 103, may communicate with each electronic product based on IoT, and may control each electronic product based on user setting data.

The display device 100 according to the embodiment may include a flexible display manufactured on a thin and flexible substrate. The flexible display may maintain characteristics of a conventional flat panel display while being bent or rolled like paper.

In the flexible display, visual information may be implemented by independently controlling emission of unit pixels arranged in a matrix form. The unit pixel means a minimum unit for implementing one color. The unit pixel of the flexible display may be implemented by a light-emitting device. In the embodiment, the light-emitting device may be a micro-LED or a nano-LED, but is not limited thereto.

FIG. 2 is an enlarged view of a first panel region A of the display device of FIG. 1.

Referring to FIG. 2, the display device 100 according to the embodiment may be manufactured such that a plurality of panel regions such as the first panel region A are mechanically and electrically connected by tiling.

The first panel region A may include a plurality of light-emitting devices 150 disposed for each unit pixel (PX of FIG. 2).

For example, the unit pixel PX may include a first sub-pixel PX1, a second sub-pixel PX2, and a third sub-pixel PX3. For example, a plurality of red light-emitting devices 150R may be disposed in the first sub-pixel PX1, a plurality of green light-emitting devices 150G may be disposed in the second sub-pixel PX2, and a plurality of blue light-emitting devices 150B may be disposed in the third sub-pixel PX3. The unit pixel PX may further include a fourth sub-pixel in which no light-emitting device is disposed, but is not limited thereto. Meanwhile, the light-emitting device 150 may be a semiconductor light-emitting device.

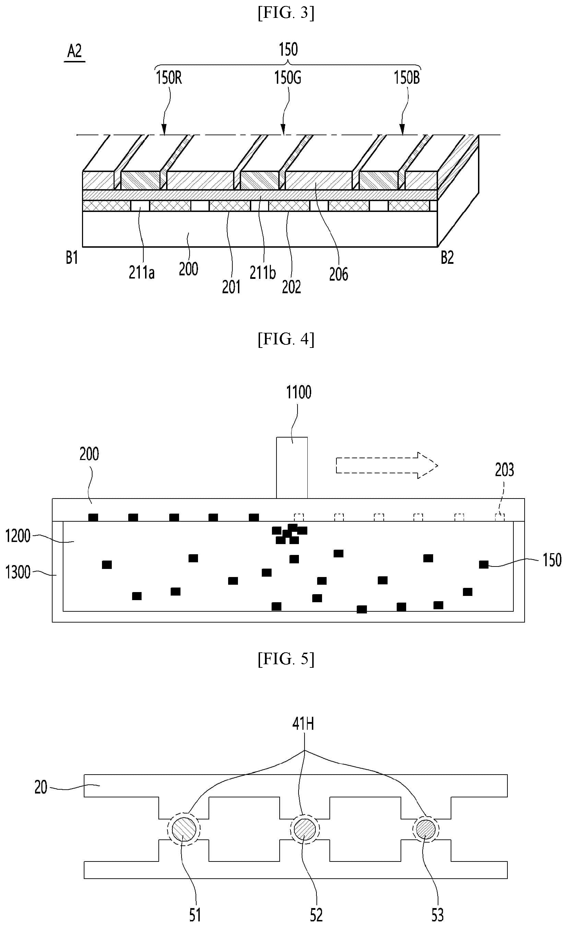

Next, FIG. 3 is a cross-sectional view taken along line B1-B2 of region B of FIG. 2.

Referring to FIG. 3, the display device 100 according to the embodiment may include a substrate 200, assembly wiring 201 and 202, a first insulating layer 211a, a second insulating layer 211b, a third insulating layer 206, and a plurality of light-emitting devices 150.

The assembly wiring may include a first assembly wiring 201 and a second assembly wiring 202 spaced apart from each other. The first assembly wiring 201 and the second assembly wiring 202 may be provided to generate a dielectrophoretic force to assemble the light-emitting devices 150. In addition, the first assembly wiring 201 and the second assembly wiring 202 may be electrically connected to electrodes of the light-emitting devices and may function as electrodes of a display panel.

The assembly wiring 201 and 202 may be formed of a transparent electrode (ITO) or may include a metal material having excellent electrical conductivity. For example, the assembly wiring 201 and 202 may be formed of at least one selected from titanium (Ti), chromium (Cr), nickel (Ni), aluminum (Al), platinum (Pt), gold (Au), tungsten (W), molybdenum (Mo), or alloys thereof.

A first insulating layer 211a may be disposed between the first assembly wiring 201 and the second assembly wiring 202, and a second insulating layer 211b may be disposed on the first assembly wiring 201 and the second assembly wiring 202. The first insulating layer 211a and the second insulating layer 211b may be an oxide film, a nitride film, or the like, but are not limited thereto.

The light-emitting device 150 may include a red light-emitting device 150, a green light-emitting device 150G, and a blue light-emitting device 150B to form a unit pixel (sub-pixel), but is not limited thereto, and red and green may be implemented by including a red phosphor and a green phosphor, respectively.

The substrate 200 may be formed of glass or polyimide. In addition, the substrate 200 may include a flexible material such as PEN (Polyethylene Naphthalate) or PET (Polyethylene Terephthalate). In addition, the substrate 200 may be a transparent material, but is not limited thereto.

The third insulating layer 206 may include an insulating and flexible material such as polyimide, PEN, or PET, and may be integrally formed with the substrate 200 to form one substrate.

The third insulating layer 206 may be a conductive adhesive layer having adhesiveness and conductivity, and the conductive adhesive layer has flexibility so that a flexible function of the display device can be enabled. For example, the third insulating layer 206 may be a conductive adhesive layer such as an anisotropic conductive film (ACF), an anisotropic conductive medium, or a solution including conductive particles. The conductive adhesive layer may be a layer that is electrically conductive in a vertical direction with respect to a thickness and electrically insulating in a horizontal direction with respect to the thickness.

The third insulating layer 206 may include an assembly hole 203 into which the light-emitting device 150 is inserted. Accordingly, during self-assembly, the light-emitting device 150 may be easily inserted into the assembly hole 203 of the third insulating layer 206. The assembly hole 203 may be referred to as an insertion hole, a fixing hole, or an alignment hole.

A spacing between the assembly wiring 201 and 202 is formed to be smaller than a width of the light-emitting device 150 and a width of the assembly hole 203, so that an assembly position of the light-emitting device 150 using an electric field can be more precisely fixed.

The third insulating layer 206 is formed on the assembly wiring 201 and 202 to protect the assembly wiring 201 and 202 from a fluid 1200 and to prevent leakage of a current flowing through the assembly wiring 201 and 202. The third insulating layer 206 may be formed of an inorganic insulator such as silica or alumina, or an organic insulator, in a single layer or multiple layers.

In addition, the third insulating layer 206 may include an insulating and flexible material such as polyimide, PEN, or PET, and may be integrally formed with the substrate 200 to form one substrate.

The third insulating layer 206 may be an insulating layer having adhesiveness or a conductive adhesive layer having conductivity. The third insulating layer 206 has flexibility so that a flexible function of the display device can be enabled.

The third insulating layer 206 has a barrier, and the assembly hole 203 may be formed by the barrier. For example, when forming the substrate 200, a part of the third insulating layer 206 is removed so that each of the light-emitting devices 150 may be assembled in the assembly hole 203 of the third insulating layer 206.

The assembly hole 203 to which the light-emitting devices 150 are coupled is formed in the substrate 200, and a surface on which the assembly hole 203 is formed may contact the fluid 1200. The assembly hole 203 may guide an accurate assembly position of the light-emitting device 150.

Meanwhile, the assembly hole 203 may have a shape and size corresponding to a shape of the light-emitting device 150 to be assembled at a corresponding position. Accordingly, it is possible to prevent another light-emitting device from being assembled in the assembly hole 203 or a plurality of light-emitting devices from being assembled therein.

FIG. 4 is a diagram illustrating an example in which a light-emitting device according to an embodiment is assembled on a substrate by a self-assembly method, and a self-assembly method of the light-emitting device will be described with reference to the drawings.

The substrate 200 may be a panel substrate of a display device. In the following description, the substrate 200 will be described as a case where the substrate 200 is a panel substrate of a display device, but the embodiment is not limited thereto.

Referring to FIG. 4, a plurality of light-emitting devices 150 may be introduced into a chamber 1300 filled with a fluid 1200. The fluid 1200 may be water such as ultra-pure water, but is not limited thereto. The chamber may be referred to as a water tank, a container, or a vessel.

Thereafter, the substrate 200 may be disposed on the chamber 1300. According to an embodiment, the substrate 200 may be introduced into the chamber 1300.

As illustrated in FIG. 3, a pair of assembly wiring 201 and 202 corresponding to each of the light-emitting devices 150 to be assembled may be disposed on the substrate 200.

Referring to FIG. 4, after the substrate 200 is disposed, an assembly apparatus 1100 including a magnetic material may move along the substrate 200. As the magnetic material, for example, a magnet or an electromagnet may be used. The assembly apparatus 1100 may move in contact with the substrate 200 in order to maximize a region in which a magnetic field affects the fluid 1200. According to an embodiment, the assembly apparatus 1100 may include a plurality of magnetic materials or may include a magnetic material having a size corresponding to that of the substrate 200. In this case, a movement distance of the assembly apparatus 1100 may be limited within a predetermined range.

By a magnetic field generated by the assembly apparatus 1100, the light-emitting devices 150 in the chamber 1300 may move toward the assembly apparatus 1100.

While moving toward the assembly apparatus 1100, the light-emitting device 150 may enter the assembly hole 203 by a dielectrophoretic force (DEP force) and may contact the substrate 200.

Specifically, the assembly wiring 201 and 202 form an electric field by a power supplied from outside, and by this electric field, a dielectrophoretic force may be formed between the assembly wiring 201 and 202. By this dielectrophoretic force, the light-emitting device 150 may be fixed in the assembly hole 203 on the substrate 200.

By the electric field applied by the assembly wiring 201 and 202 formed in the substrate 200, it is possible to prevent the light-emitting device 150 contacting the substrate 200 from being separated due to movement of the assembly apparatus 1100. According to the embodiment, since a time required for each of the light-emitting devices 150 to be assembled on the substrate 200 can be rapidly reduced by the self-assembly method using the above-described electromagnetic field, a large-area high-resolution display can be implemented more rapidly and economically.

At this time, a predetermined solder layer (not shown) may be formed between the light-emitting device 150 assembled on the assembly hole 203 of the substrate 200 and an assembly electrode to improve a bonding force of the light-emitting device 150.

Next, a molding layer (not shown) may be formed in the assembly hole 203 of the substrate 200. The molding layer may be a transparent resin or a resin including a reflective material or a scattering material.

FIG. 5 is a conceptual view of an assembly substrate in which semiconductor light-emitting devices are assembled, studied in internally developed technology. Referring to FIG. 5, a plurality of assembly wirings 20 may be disposed on a substrate (not shown), and an insulating film and a barrier may be disposed on the plurality of assembly wirings 20. In addition, the barrier may include a first assembly hole 41H in which a first semiconductor light-emitting device is to be assembled. Meanwhile, the semiconductor light-emitting devices may have different sizes according to colors to be emitted for simultaneous assembly. In addition, sizes of the assembly holes may correspond thereto. The first semiconductor light-emitting device 51 may be larger than the second semiconductor light-emitting device 52, and the second semiconductor light-emitting device 52 may be larger than the third semiconductor light-emitting device 53. In addition, the first semiconductor light-emitting device 51, the second semiconductor light-emitting device 52, and the third semiconductor light-emitting device 53 may emit different colors.

Meanwhile, when assembly is performed in an order of chip sizes, an assembly time increases, and since sizes of the second semiconductor light-emitting device 52 and the third semiconductor light-emitting device 53 are smaller than that of the first assembly hole 41H, there is a problem in that the second semiconductor light-emitting device 52 and the third semiconductor light-emitting device 53 are assembled in the first assembly hole 41H and cannot escape, thereby causing color mixing.

In addition, as a size of the chip becomes smaller, there is a problem in that it is difficult to secure beta characteristics of R, G, and B chips.

Hereinafter, embodiments for solving the above problems will be described.

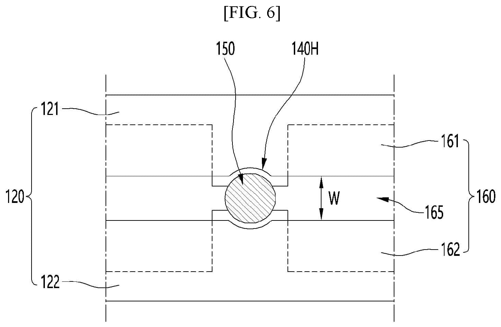

FIG. 6 is a conceptual view of an assembly substrate for semiconductor light-emitting devices for display pixels according to a first embodiment. Referring to FIG. 6, the first embodiment may include a plurality of assembly wirings 120, a barrier 160 disposed on the plurality of assembly wirings 120, an assembly hole 140H provided in the barrier, and a semiconductor light-emitting device 150 assembled in the assembly hole 140H.

The plurality of assembly wirings 120 may include a first assembly wiring 121 and a second assembly wiring 122. The first assembly wiring 121 and the second assembly wiring 122 are disposed to be spaced apart from each other, and alternating current having opposite polarities may be applied thereto to generate a DEP force to assemble the semiconductor light-emitting device.

The barrier 160 may include a first barrier 161 and a second barrier 162 disposed to be spaced apart from each other. The first barrier 161 may be disposed on the first assembly wiring 121, and the second barrier 162 may be disposed on the second assembly wiring 122. In addition, the barrier 160 may include the assembly hole 140H. The assembly hole 140H may vertically overlap the plurality of assembly wirings 120.

At this time, as the first barrier 161 and the second barrier 162 are spaced apart from each other, a barrier channel 165 may be formed. A width W of the barrier channel 165 may be a distance between the first barrier 161 and the second barrier 162. Meanwhile, a diameter of the assembly hole 140H may be greater than a diameter of the semiconductor light-emitting device 150. In addition, the width W of the barrier channel 165 may be smaller than the diameter of the semiconductor light-emitting device 150. In addition, the width W of the barrier channel 165 may be greater than a diameter of a semiconductor light-emitting device emitting a color different from that of the semiconductor light-emitting device 150.

Accordingly, when a semiconductor light-emitting device having a size different from that of the semiconductor light-emitting device 150 corresponding to the assembly hole 140H is mis-assembled, it may escape through the barrier channel 165 by a magnet. Accordingly, the embodiment can prevent mis-assembly during self-assembly to prevent color mixing, and semiconductor light-emitting devices of R, G, and B colors can be simultaneously assembled, thereby providing a technical effect of significantly reducing an assembly time.

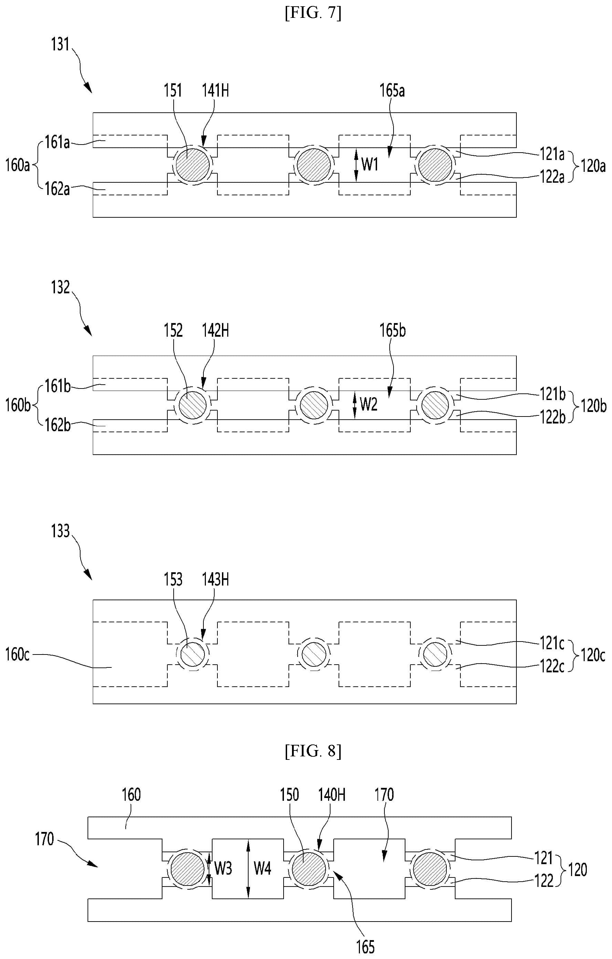

FIG. 7 is a plan view of an assembly substrate for semiconductor light-emitting devices for display pixels according to a second embodiment. Referring to FIG. 7, the second embodiment may include a first assembly region 131 in which a first semiconductor light-emitting device 151 is assembled, a second assembly region 132 in which a second semiconductor light-emitting device 152 is assembled, and a third assembly region 133 in which a third semiconductor light-emitting device 153 is assembled. The first semiconductor light-emitting device 151, the second semiconductor light-emitting device 152, and the third semiconductor light-emitting device 153 may emit different colors. For example, the first semiconductor light-emitting device 151 may emit a red color, the second semiconductor light-emitting device 152 may emit a green color, and the third semiconductor light-emitting device 153 may emit a blue color, but are not limited thereto. In addition, a diameter of the first semiconductor light-emitting device 151 may be greater than a diameter of the second semiconductor light-emitting device 152, and a diameter of the second semiconductor light-emitting device 152 may be greater than that of the third semiconductor light-emitting device 153. In addition, an assembly voltage of the third semiconductor light-emitting device 153 may be greater than an assembly voltage of the second semiconductor light-emitting device 152, and the assembly voltage of the second semiconductor light-emitting device 152 may be greater than that of the first semiconductor light-emitting device 151.

First, in the first assembly region 131, a plurality of first assembly wiring 120a may include a first-first assembly wiring 121a and a first-second assembly wiring 122a. In addition, a first barrier 160a may be disposed on the first assembly wiring 120a. The first barrier 160a may include a first-first barrier 161a disposed on the first-first assembly wiring 121a and a first-second barrier 162a disposed on the first-second assembly wiring 122a. The first-first barrier 161a and the first-second barrier 162a may be disposed to be spaced apart from each other.

The first barrier 160a includes a first assembly hole 141H, and the first semiconductor light-emitting device 151 may be assembled in the first assembly hole 141H. A diameter of the first assembly hole 141H may be greater than a diameter of the first semiconductor light-emitting device 151.

In addition, in the first assembly region 131, as the first-first barrier 161a and the first-second barrier 162a are spaced apart from each other, a first barrier channel 165a may be formed. A width W1 of the first barrier channel 165a may be smaller than a diameter of the first assembly hole 141H. In addition, the width W1 of the first barrier channel 165a may be smaller than a diameter of the first semiconductor light-emitting device 151.

In addition, the width W1 of the first barrier channel 165a may be greater than a diameter of the second semiconductor light-emitting device 152. The width W1 of the first barrier channel 165a may be greater than a diameter of the third semiconductor light-emitting device 153.

Meanwhile, in the first semiconductor light-emitting device 151, an assembly force of the first assembly wiring 120a may be greater than a magnetic force of an assembly magnet. On the other hand, in the second semiconductor light-emitting device 152 and the third semiconductor light-emitting device 153, the magnetic force of the assembly magnet may be greater than the assembly force of the first assembly wiring 120a.

Accordingly, in the second embodiment, even when the second semiconductor light-emitting device 152 or the third semiconductor light-emitting device 153 is assembled in the first assembly hole 141H, a mis-assembled chip may escape through the first barrier channel 165a by the assembly magnet.

In addition, in the second assembly region 132, a second assembly wiring 120b is disposed, and a second barrier 160b may be disposed on the second assembly wiring 120b. The second barrier 160b includes a second assembly hole 142H, and a second semiconductor light-emitting device may be assembled in the second assembly hole 142H. A diameter of the second assembly hole 142H may be smaller than a diameter of the first semiconductor light-emitting device 151, so that the first semiconductor light-emitting device 151 cannot be assembled.

The second barrier 160b may include a second-first barrier 161b and a second-second barrier 162b disposed to be spaced apart from each other. In addition, in the second assembly region 132, as the second-first barrier 161b and the second-second barrier 162b are spaced apart from each other, a second barrier channel 165b may be formed. A width W2 of the second barrier channel 165b may be smaller than a diameter of the second assembly hole 142H. In addition, the width W2 of the second barrier channel 165b may be smaller than a diameter of the second semiconductor light-emitting device 152. In addition, the width W2 of the second barrier channel 165b may be greater than a diameter of the third semiconductor light-emitting device 153.

Accordingly, in the second embodiment, even when the third semiconductor light-emitting device 153 is assembled in the second assembly hole 142H, a mis-assembled chip may escape through the second barrier channel 165b by an assembly magnet.

In addition, in the third assembly region 133, a third barrier 160c disposed on a third assembly wiring 120c may include a third assembly hole 143H, and the third semiconductor light-emitting device 153 may be assembled in the third assembly hole 143H. A diameter of the third assembly hole 143H may be smaller than a diameter of the second semiconductor light-emitting device 152 and may be greater than a diameter of the third semiconductor light-emitting device 153. In addition, the third barrier 160c may not include a barrier channel.

Accordingly, the second embodiment can provide a technical effect in that semiconductor light-emitting devices of R, G, and B colors can be simultaneously assembled, thereby significantly reducing an assembly process time. In addition, mis-assembled chips may escape through the barrier channel to prevent color mixing.

FIG. 8 is a plan view of an assembly substrate for semiconductor light-emitting devices for display pixels according to a third embodiment. Referring to FIG. 8, a barrier 160 may be disposed on a plurality of assembly wirings 120. The barrier 160 may vertically overlap the assembly wiring 120. In addition, the barrier 160 may include an assembly hole 140H. A semiconductor light-emitting device 150 may be disposed in the assembly hole 140H. Meanwhile, in the third embodiment, as barriers are disposed to be spaced apart from each other, a barrier channel 165 may be provided. In addition, the barrier channel 165 may have a first width W3 in an assembly region, but may be connected to a first region 170 outside the assembly region. A width W4 of the first region 170 may be greater than the first width W3 of the barrier channel 165. The first region 170 may not vertically overlap the assembly wiring 120.

Meanwhile, the first region 170 may be a region for collecting chips that are not assembled and escape through the barrier channel 165.

Accordingly, the third embodiment can simultaneously assemble R, G, and B chips, and the barrier includes the first region between assembled semiconductor light-emitting devices, so that unassembled chips move to the first region and can be easily collected.

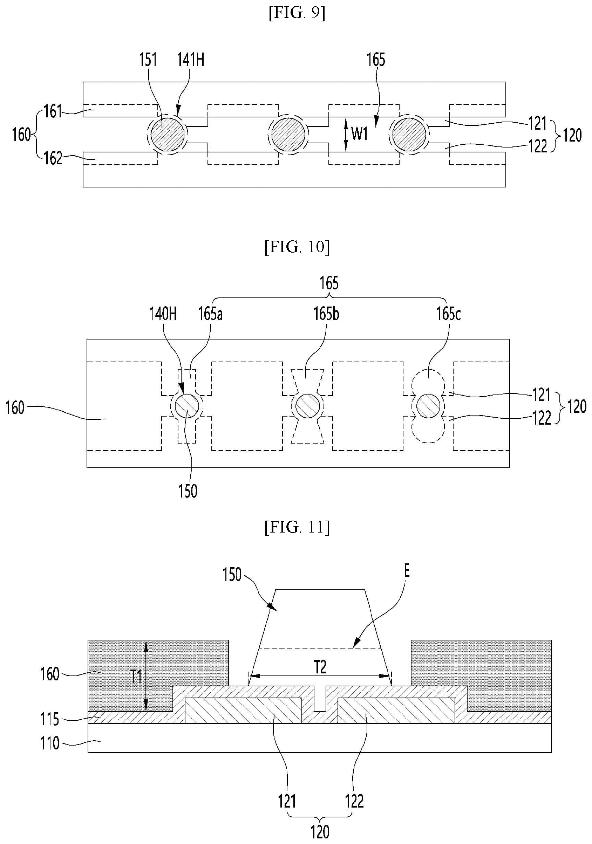

FIG. 9 is a plan view of an assembly substrate for semiconductor light-emitting devices for display pixels according to a fourth embodiment. Referring to FIG. 9, the assembly hole 141H may be positioned to vertically overlap the plurality of assembly wirings 120. At this time, the assembly hole 141H may be biased toward one side between the plurality of assembly wirings 120. When alternating voltages having opposite polarities are applied to the plurality of assembly wirings 120 to generate a DEP force and assemble the semiconductor light-emitting device 151, the DEP force may be strongest in a region between the plurality of assembly wirings 120. In addition, the semiconductor light-emitting device 151 may vertically overlap the plurality of assembly wirings 120 only at a part of a bottom surface thereof. Accordingly, when the assembly hole 141H is formed to be biased toward one side between the plurality of assembly wirings 120, the semiconductor light-emitting device may be assembled between the plurality of assembly wirings 120 where the DEP force is strongest, and a tolerance of the semiconductor light-emitting device assembled in each assembly hole 141H can be reduced.

FIG. 10 is a plan view of an assembly substrate for semiconductor light-emitting devices for display pixels according to a fifth embodiment. Referring to FIG. 10, in the fifth embodiment, the barrier 160 may include an assembly hole 140H on a plurality of assembly wirings 120. The assembly hole 140H may vertically overlap the first assembly wiring 121 and the second assembly wiring 122. In addition, the barrier 160 may include a barrier channel 165 disposed on the assembly wiring 120. The barrier channel 165 may be in contact with the assembly hole 140H. The barrier channel 165 may be symmetrically disposed with respect to the semiconductor light-emitting device 150. Meanwhile, the barrier channel 165 may vertically overlap any one of the first assembly wiring 121 and the second assembly wiring 122. The barrier channel 165 vertically overlaps only one of the plurality of assembly wirings 120, and accordingly, a DEP force may not be formed or may be weak in the barrier channel 165.

Accordingly, a chip positioned in the barrier channel 165 may not be assembled. Accordingly, a chip not assembled in the assembly hole 140H may move to the barrier channel 165 and may be collected.

In addition, the barrier channel 165 may include a first barrier channel 165a, a second barrier channel 165b, and a third barrier channel 165c. The first barrier channel 165a may have a rectangular shape. In addition, the second barrier channel 165b may have a trapezoidal shape. In addition, the third barrier channel 165c may have a circular or elliptical shape.

Accordingly, in the fifth embodiment, the barrier channel vertically overlaps one of the plurality of assembly wirings, and since an assembly force is not applied to the barrier channel, a chip positioned in the barrier channel is not assembled and may be collected. In addition, the barrier channel may have a shape such as a rectangle, a trapezoid, a circle, or an ellipse.

FIG. 11 is a cross-sectional view of an assembly substrate for semiconductor light-emitting devices for display pixels according to a sixth embodiment. Referring to FIG. 11, a plurality of assembly wirings 120 may be disposed on a substrate 110, and an insulating layer 115 may be disposed to cover the plurality of assembly wirings 120. In addition, a barrier having an assembly hole may be disposed on the insulating layer 115. In addition, a semiconductor light-emitting device 150 may be disposed in the assembly hole.

At this time, a height of the barrier 160 may be higher than a center of gravity E of the semiconductor light-emitting device 150. An upper surface of the barrier 160 may be positioned higher than the center of gravity E of the semiconductor light-emitting device 150. Accordingly, when the semiconductor light-emitting device 150 is correctly assembled, it is possible to prevent a problem in which the semiconductor light-emitting device is separated from the assembly hole due to collision with another chip.

In addition, a thickness T1 of the barrier 160 may be smaller than a diameter T2 of the semiconductor light-emitting device 150. Specifically, the thickness T1 of the barrier 160 may be smaller than 1/2 of the diameter T2 of the semiconductor light-emitting device 150. Accordingly, when the semiconductor light-emitting device 150 is tilted and mis-assembled, it can be separated from the assembly hole due to collision with another chip, thereby providing a technical effect of improving a correct assembly rate of semiconductor light-emitting devices.

The assembly substrate for semiconductor light-emitting devices for display pixels and the display device including the same according to the embodiment can provide a technical effect of preventing color mixing of semiconductor light-emitting devices.

For example, according to the embodiment, semiconductor light-emitting devices emitting different colors can escape through the barrier channel so that color mixing can be prevented.

In addition, the embodiment can provide a technical effect of implementing simultaneous assembly of semiconductor light-emitting devices.

For example, according to the embodiment, semiconductor light-emitting devices having different sizes can be distinguished using the barrier channel and can be simultaneously assembled.

In addition, the embodiment can provide a technical effect of reducing an assembly time of semiconductor light-emitting devices.

For example, according to the embodiment, the assembly time can be significantly reduced through simultaneous assembly.

In addition, the embodiment can provide a technical effect of facilitating collection of unassembled chips.

For example, according to the embodiment, unassembled chips can be collected by forming a collection region in an area adjacent to the barrier channel.

In addition, the embodiment can provide a technical effect of improving a correct assembly rate of semiconductor light-emitting devices.

For example, according to the embodiment, the correct assembly rate can be improved by designing a height of the barrier to consider a diameter and a center of gravity of the semiconductor light-emitting device.

Although the embodiments of the present invention have been described above, those of ordinary skill in the art will readily understand that the present invention may be variously modified and changed without departing from the spirit and scope of the present invention defined in the following claims.

### [Industrial Applicability]

The embodiment can be applied to a display field for displaying an image or information.

The embodiment can be applied to a display field for displaying an image or information using semiconductor light-emitting devices.

The embodiment can be applied to a display field for displaying an image or information using micro-scale or nano-scale semiconductor light-emitting devices.

## Claims

1. An assembly substrate for semiconductor light-emitting devices for display pixels, comprising:
a substrate;
a plurality of assembly wirings disposed on the substrate;
a barrier disposed on the plurality of assembly wirings and comprising an assembly hole; and
a barrier channel disposed adjacent to the assembly hole.

2. The assembly substrate for semiconductor light-emitting devices for display pixels according to claim 1,
wherein the assembly hole comprises:
a first assembly hole in which a first semiconductor light-emitting device is assembled and
a second assembly hole in which a second semiconductor light-emitting device is assembled, and
wherein the barrier channel comprises a first barrier channel adjacent to the first assembly hole and a second barrier channel adjacent to the second assembly hole.

3. The assembly substrate for semiconductor light-emitting devices for display pixels according to claim 2,
wherein a width of the first barrier channel is smaller than a diameter of the first assembly hole.

4. The assembly substrate for semiconductor light-emitting devices for display pixels according to claim 2,
wherein a width of the first barrier channel is smaller than a diameter of the first semiconductor light-emitting device and greater than a diameter of the second semiconductor light-emitting device.

5. The assembly substrate for semiconductor light-emitting devices for display pixels according to claim 4,
wherein a width of the first barrier channel is greater than a height of the second semiconductor light-emitting device.

6. The assembly substrate for semiconductor light-emitting devices for display pixels according to claim 1,
wherein the assembly hole comprises a plurality of assembly holes,
and the barrier channel is integrally formed together with the plurality of assembly holes.

7. The assembly substrate for semiconductor light-emitting devices for display pixels according to claim 1,
wherein the assembly hole comprises a plurality of assembly holes,
and the assembly substrate further comprises a first region disposed between the plurality of assembly holes and connected to the barrier channel, and
wherein a width of the first region is greater than a width of the barrier channel.

8. The assembly substrate for semiconductor light-emitting devices for display pixels according to claim 1,
wherein the barrier channel is disposed to overlap any one of the plurality of assembly wirings in a vertical direction.

9. The assembly substrate for semiconductor light-emitting devices for display pixels according to claim 1,
wherein a height of the barrier is greater than a height corresponding to a center of gravity of the semiconductor light-emitting device.

10. The assembly substrate for semiconductor light-emitting devices for display pixels according to claim 1,
wherein a height of the barrier is smaller than half of a diameter of the semiconductor light-emitting device.

11. A display device comprising the assembly substrate for semiconductor light-emitting devices for display pixels according to any one of claims 1 to 10.
